# EUROPEAN PATENT APPLICATION

(11) **EP 4 826 520 A1**
(43) Date of publication of application: **21.10.2026**
(21) Application number: 25170709.7
(22) Date of filing: 15.04.2025
(51) Int. Cl.: G06F 7/00, G06E 1/00, G06N 3/067, G11C 13/04

(54) **OPTICAL INPUT AND OUTPUT WITH DYNAMICAL ALL-OPTICAL MEMORIES**

(71) Applicant: Akhetonics GmbH, 10823 Berlin (DE)
(72) Inventor: Dr. KISSNER, Michael, 63303 Dreieich (DE); Dr. DEL BINO, Leonardo, 80997 München (DE); GOLDMANN, Mirko, 10437 Berlin (DE); ASMAT, Maxim, 10117 Berlin (DE)
(74) Representative: Schmidt, Sebastian

(57) **Abstract**

An optical input-output device comprises an optical network (1) having a plurality of read units (1.1) and a plurality of write units (1.2) and is configured for performing read and write operations on an optical medium (2) having a plurality of memory cells (2.1). Each read unit (1.1) is configured to receive a read signal and propagate the read signal further towards the optical medium (2) for reading out information stored in a memory cell (2.1). Each read unit (1.1) is further configured to receive the read signal modulated by the memory cell back from the optical medium (2). Each write unit (1.2) is configured to receive a write signal and propagate the write signal further towards the optical medium (2) for writing information into a memory cell.

## Description

### Technical field

The invention relates to devices and methods for optical input and output with dynamical all-optical memories.

### Background

Modern data networks with high capacity and high-performance computing devices require large-scale memories and associated structures for efficient input and output to enable storing and processing vast amounts of information as quickly as possible. However, traditional compute and memory architectures rely on electronic redistribution and interconnect structures that are limited by electronic clock rates and consume large amounts of power mainly due to high ohmic losses.

A promising alternative approach may be based on optical components that can operate at the speed of light. However, traditional optical systems are based on bulky devices that are difficult to integrate with semiconductor manufacturing. Some advances in silicon photonics have enabled co-integrating compact and energy-efficient laser systems as well as optical interfaces and interconnects with more traditional electronic storage and compute hardware. However, most of these systems still heavily rely on electronic components, e.g., for computing, storage and electro-optical conversion. This severely limits the scalability, efficiency and flexibility of such hybrid platforms.

Thus, an object of the invention is to overcome such limitations and provide optical input-output devices and methods that improve upon the available systems and methods for optical processing.

This object of the invention is achieved by the optical input output device, optical system and the optical input-output method as described in the appended independent claims. Advantageous developments and embodiments are described in the dependent claims.

In a first aspect, the invention relates to an optical input-output device comprising an optical network having a plurality of read units and a plurality of write units. The optical input-output device is configured for performing read and write operations on an optical medium having a plurality of memory cells.

Each read unit is configured to receive a read signal and propagate the read signal further towards the optical medium for reading out information stored in a memory cell of the plurality of memory cells. Each read unit is further configured to receive the read signal modulated by the memory cell back from the optical medium and couple the modulated read signal back into the optical network for further processing. Each write unit is configured to receive a write signal and propagate the write signal further towards the optical medium, preferably, a memory cell of the plurality of memory cells, for writing information into a memory cell of the plurality of memory cells by interacting with the optical medium, preferably with the memory cell.

The proposed optical input output device allows for all optical and massive parallel processing of optical payload. In particular, means are provided for maintaining optical communication/coupling between an optical network and an optical medium using optical signals. The proposed invention thus enables all-optical input and output as well as optical storage in an optical memory. Therefore, the optical input output device enables fast, efficient and fully integrated optical processing without relying on electronic components while maintaining enough flexibility and adaptability for maintenance, tuning and further scalability.

For example, the optical network may be coupled to or may be a part of an optical network for optical computing. The further processing of the modulated read signals may be optical computing. The optical computing may comprise a matrix-vector multiplication.

For the sake of clarity, here and in the following an optical coupling and/or the standing in optical communication between two components, e.g., a read or write unit and the optical medium or a memory cell, means that an effective optical mode coupling/overlap has been established between those two components that allows for the exchange of information via the coupled/overlapping optical modes and signals propagating in those modes. For example, a read signal may propagate in an optical mode that has at least partial spatial overlap with a memory cell of the optical medium so that information can be read out from said memory cell.

A signal, e.g., a read signal or write signal, in the spirit of this disclosure may refer to a pulsed or continuous-wave optical signal. Each read unit may process a different optical read signal and each write unit may process a different optical write signal.

It is also noted that the term "optical" in the sense of the present disclosure refers to electromagnetic radiation in general and is not necessarily to be understood as limiting with respect to a specific frequency or wavelength range of the electromagnetic radiation used. For example, a signal in the spirit of the present disclosure may refer to a wavelength range in the visible spectrum but may also refer to microwave radiation or electromagnetic radiation in the THz range. Accordingly, the invention is applicable and practicable in a wide range of the electromagnetic spectrum.

The plurality of memory cells may comprise first memory cells and second memory cells. The plurality of memory cells of the optical medium as specified by the claims may be a subset of all memory cells of the optical medium. Preferably, the number of memory cells of the plurality of memory cells is larger than 2. A first memory cell may be partially spatially overlapping with a second memory cell.

The plurality of read units of the optical network may be a subset of all read units of the optical network. Preferably, the number of read units of the plurality of multiplier units is larger than 2. The plurality of write units of the optical network may be a subset of all write units of the optical network. Preferably, the number of write units of the plurality of write units is larger than 2.

The number of memory cells of the plurality of memory cells may be larger than the number of read units of the plurality of read units and/or larger than the number of write units of the plurality of write units.

The plurality of read units may be spatially separate from each other. Each read unit of the plurality of read units may be configured to optically couple and/or optically address a different memory cell. The plurality of write units may be spatially separate from each other. Each write unit of the plurality of write units may be configured to optically couple and/or optically address a different memory cell.

The optical network may comprise a plurality of read/write units, wherein the plurality of read/write units may comprise, or consist of, the plurality of read units and the plurality of write units. The plurality of read/write units may be spatially separate from each other. Each read/write unit of the plurality of read/write units may be configured to optically couple and/or optically address a different memory cell of the plurality of memory cells.

Each read/write unit may comprise a read unit for reading information from a memory cell, e.g., a first memory cell, and a write unit for writing information into the same memory cell, e.g., the first memory cell. The read unit and the write unit of a same read/write unit may be spatially separate from each other to avoid interference between a write signal and a read signal.

The optical medium may comprise a plurality of tracks. The tracks may be spaced apart from each other, preferably the tracks are not overlapping with each other. For example, each track may be a circular track or a linear track. Each track may comprise at least one memory cell. Preferably, each track comprises a plurality of memory cells. Optionally, each track comprises spatially overlapping memory cells and can thus be considered as a continuous track of memory cells. Each read/write unit of the plurality of read/write units, or each pair of a read unit and a write unit of the plurality of read units and write units, may be optically coupled to a different track of the plurality of tracks.

The optical medium may comprise, or consist of, (optical) phase change material. The state or phase of the phase change material or portions thereof may be sensitive to optical signals. Thus, information may be stored in a phase of the phase change material. A memory cell of the optical medium may comprise a portion of the phase change material. A state/phase of a memory cell may then correspond to a phase/state of the portion of the phase change material of said memory cell.

The optical medium may comprise or consists of a patterned optical material layer. The patterning may be achieved by writing information to the optical material layer. The optical medium or the patterned optical material layer may comprise or consist of at least one first-type region and at least one second-type region. Preferably, the optical medium or the patterned optical material layer has a plurality of first-type regions and second-type regions. The plurality of first-type regions and second-type regions may form a plurality of memory cells of the optical medium. The patterning of the optical material layer into the at least one first-type region and the at least one second-type region may determine the information stored in the plurality of memory cells of the optical medium.

A memory cell may comprise of consist of a first-type region. In this case, the information stored in the memory cell may correspond to a first information value, e.g., a bit value 0 or logic 0. A memory cell may comprise of consist of a second-type region. In this case, the information stored in the memory cell may correspond to a second information value different from the first information value, e.g., a bit value 1 or logic 1.

The optical medium or the patterned optical material may comprise, preferably consists of, a phase change material (layer). Exemplarily, the phase change material may comprise or consist of germanium-antimony-tellurium (GST).

Optionally, at least one or each first-type region comprises, preferably consists of, phase change material being in a first phase. Optionally, at least one or each second type region comprises, preferably consists of, phase change material being in a second phase. Preferably, the first phase is different from the second phase. In particular, a transmittance and/or absorbance of the first phase may be different from the second phase.

The first phase and the second phase may be at least one of a crystalline phase and a transparent phase of the phase change material. For example, the first phase may be a crystalline phase of the phase change material and the second phase may be an amorphous phase of the phase change material. Alternatively, the first phase is an amorphous phase and the second phase is a crystalline phase.

Read and write signals may be distinct in terms of power and/or wavelength. Each read signal may optically interact (weakly) with a memory cell for reading out information stored in the memory cell without changing the state/phase of the memory cell. This may comprise probing the memory cell and thereby modulating the read signal. The modulation of the read signal may be at least indicative of the information stored in the memory cell. Thus, by comparing the read signal that is received by a read unit before probing the memory cell with the modulated read signal received back from the memory cell, the information stored in the memory cell can be obtained. The modulation can be an amplitude, phase or frequency modulation.

Each write signal may optically interact (strongly) with a memory cell for writing or storing information into the memory cell by changing the state/phase of the memory cell and/or an optical property of the memory cell. The state and/or optical property is then indicative of the information stored in the memory cell. The plurality of write units can be used to pattern the phase change material in order to store large amounts of information in the optical medium.

The optical network may comprise or consist of or be integrated in an integrated photonic circuit, optionally an integrated nanophotonic circuit. The integrated photonic circuit may consist of or be embedded in a microchip. For example, the optical network may be a microchip or a portion thereof. The optical network may comprise or consist of or be embedded in one or more layers of an integrated photonic circuit and/or a microchip.

The optical network may be substantially planar. Optionally, the optical network may comprise or consist of or be arranged in one or more parallel, overlapping or stacked layers. The optical network may comprise or be overlapping a substrate. For example, the substrate of the optical network may comprise, or consist of, Silicon.

The optical network or the one or more layers of the optical network may be spaced apart from the optical medium in a direction normal to the one or more layers of the optical medium and/or normal to the one or more layers of the optical network, e.g., when the optical medium is mounted and/or when the optical medium is in optical communication with the optical network and/or when the optical medium is optically coupled with the optical network.

The plurality of read units may be arranged in one or more parallel layers of the optical network. Optionally, the plurality of read units are overlapping a same substrate, e.g., a substrate of the optical network. The plurality of write units may be arranged in one or more parallel layers of the optical network. Optionally, the plurality of write units are overlapping a same substrate, e.g., a substrate of the optical network. The plurality of read units and the plurality of write units may be arranged in a same layer. The plurality of read units and the plurality of write units may also be arranged in two different layers. The two different layers may be overlapping and/or stacked over each other.

The optical network may comprise or consists of a waveguide array. The waveguide array may be arranged in one or more layers of the optical network. The waveguide array may comprise the plurality of read units and/or the plurality of write units. Each write unit of the plurality of write units and/or each read unit of the plurality of read units may be coupled or connected to a waveguide of the waveguide array. The plurality of read units and/or write units may be coupled by or be connected to the waveguide array and/or may be coupled by or connected to waveguides of the waveguide array.

Optionally, the optical network comprises or consists of a Mach-Zehnder interferometer (MZI) network. The plurality of read units and/or write units may form or be part of a MZI network. The MZI network may comprise a plurality of Mach-Zehnder interferometers (MZls). At least one arm of each MZI may comprise at least one read unit or write unit.

Alternatively, the optical network may comprise or consist of a Crossbar array. The plurality of read units and/or write units may form or be part of a crossbar array. The Crossbar array may comprise a plurality of unit cells. Each unit cell of the crossbar array may comprise at least one read unit or write unit.

Each read unit of the plurality of read units may comprise a first coupler. Each first coupler may be configured for coupling a read signal out of a layer of the optical network and propagating the read signal further towards the optical medium. Specifically, a first coupler may be configured to propagate a read signal towards a memory cell of the optical medium, i.e., a memory cell that (currently) is optically coupled or stands in optical communication with the read unit to which the first coupler belongs.

Each read unit of the plurality of read units may comprise a second coupler. Each second coupler may be configured for coupling a modulated read signal coming from the optical medium back into a layer of the optical network. Specifically, a second coupler may be configured to receive a modulated read signal from a memory cell of the optical medium, i.e., a memory cell that (currently) is optically coupled or stands in optical communication with the read unit to which the second coupler belongs.

Each write unit of the plurality of write units may comprise a third coupler. Each third coupler may be configured for coupling a write signal out of a layer of the optical network and propagating the write signal further towards the optical medium. Specifically, a third coupler may be configured to propagate a write signal towards a memory cell of the optical medium, i.e., a memory cell that (currently) is optically coupled or stands in optical communication with the write unit to which the third coupler belongs.

The first coupler may be spatially separate from the second coupler. The third coupler may be spatially separate from the first and second coupler. Each first, second and/or third coupler may be a mirror. Advantageously, each first, second and/or third coupler is a grating coupler, preferably a focused grating coupler. A periodicity of the third grating coupler may be different from a periodicity of the first and/or second grating coupler.

The first couplers and the second couplers of the plurality of read units may be in a same first layer of the optical network. Optionally, the third coupler of the plurality of write units are in a same second layer of the optical network. The first layer may be identical to the second layer. The first layer may also be different from the second layer. Specifically, the first layer may be over the second layer. The first layer may be directly on the second layer.

Each first coupler may be coupled or connected to a first waveguide of the optical network. Specifically, each first coupler may be configured to couple a read signal out of the first waveguide and propagate the read signal from the first waveguide towards the optical medium.

Each second coupler may be coupled or connected to a second waveguide of the optical network. Specifically, each second coupler may be configured to couple a modulated read signal coming from the optical medium into the second waveguide.

Each third coupler may be coupled or connected to a third waveguide of the optical network. Specifically, each third coupler may be configured to couple a write signal out of the third waveguide and propagate the write signal from the third waveguide towards the optical medium.

The optical input output device may comprise a mounting unit for receiving, mounting and/or holding the optical medium. The mounting unit may also be configured to bring the optical medium in optical communication with the optical network by mounting and/or holding the optical medium.

Preferably, the mounting unit is configured to mount the optical medium interchangeably or removably, e.g., for exchanging/replacing the optical medium by another optical medium. In this way another optical medium may be brought into optical communication with the optical network in a flexible manner.

The mounting unit may also be configured to movably mount and hold the optical medium. For example, the optical medium may be movably mounted and held for changing the relative position of the plurality of memory cells relative to the plurality of read units and/or write units. Specifically, the optical medium may be movably mounted and held for changing the memory cells of the plurality of memory cells that are optically coupled with the plurality of read units and/or the plurality of write units. This may allow to change with which memory cells of the plurality of memory cells the plurality of read units and/or write units are optically coupled (e.g., for reading and/or writing).

Optionally, the optical medium may be rotatably mounted or movable. For example, the optical medium may comprise or consist of a disc or a torus. Specifically, the optical medium may comprise or consist of a digital versatile disc (DVD).

Alternatively, the optical medium may be translatorily mounted or movable. For example, the optical medium may comprise or consist of a (substantially) linear strip or tape. Specifically, the optical medium may comprise or consist of a roll-to-roll or conveyor belt configuration.

The optical input output device may comprise a drive unit. The drive unit may be a part of the mounting unit or may be a separate component of the optical input output device.

The drive unit may be configured to move the optical medium relative to the optical network. Preferably, the drive unit is configured to move the plurality of memory cells relative to the plurality of read units and/or write units. Specifically, the drive unit may be configured to (ex-)change the memory cells optically coupled with at least one, preferably each, read and/or write unit(s) by moving the optical medium relative to the optical network.

For example, the drive unit may be configured to rotate the optical medium around a normal vector of an optical network layer. A rotation may be particular convenient when the optical medium is in the shape of a disc.

Optionally, the drive unit may be configured to translate the optical medium in a direction parallel to an in-plane vector of an optical network layer. A translation may be particular convenient when the optical medium is in the shape of a linear strip or tape.

Specifically, the drive unit may be configured to move the optical medium relative to the optical network for changing at least one memory cell of the optical medium that is optically coupled and/or in optical communication with at least one of the read and/or write units. In this way, the plurality of memory cells that are optically coupled or stand in optical communication with the plurality of read and/or write units can be (ex-)changed, e.g., from a plurality of first memory cells to a plurality of second memory cells being different from the first memory cells.

The optical network may be configured to perform at least one copy operation. A copy operation may comprise reading, by at least one read unit of the plurality of read units, information stored in a first memory cell of the optical medium. The copy operation may further comprise writing, by at least one write unit of the plurality of write units, the information read out from the first memory cell into a second memory cell of the optical medium, wherein the second memory cell is different from the first memory cell. Optionally, the second memory cell may be partially spatially overlapping with the first memory cell.

A copy operation may also comprise reading, by the plurality of read units, information stored in first memory cells of the optical medium. The copy operation may further comprise writing, by the plurality of write units, information read out from the first memory cells into second memory cells of the optical medium. Each second memory cell may be different from each first memory cell. Optionally, each second memory cell may be partially spatially overlapping with a first memory cell.

Preferably, the performing a copy operation comprises moving the optical medium relative to the optical network to change the memory cells optically coupled to the plurality of read and/or write units. The moving of the optical medium may be performed before the reading of information from the first memory cell(s) and writing of information into the second memory cell(s) of a copy operation. For example, at a first time instance a pair of a read unit and a write unit may be optically coupled to a first memory cell. At the first time instance the write unit may be configured to write information into the first memory cell. During a time interval between the first time instance and a second time instance, the drive unit may be configured to move the optical medium relative to the optical network so that the pair of read unit and write unit becomes optically coupled with a second memory cell. The second memory cell may be partially spatially overlapping with the first memory cell. Thus, at the second time instance, the read unit may still also be optically coupled to the first memory cell (i.e., an optical mode of a read signal is spatially overlapping with the first memory cell). At the second time instance, the read unit may thus be configured to (still) read out information from the first memory cell and subsequently, the write unit may be configured to write the information read out from the first memory cell into the second memory cell. This may conclude the copying of information from the first to the second memory cell. Optionally, the optical medium may also be moved during the reading and writing of a copy operation. The time interval between the first time instance and the second time instance may be significantly larger than the time interval between the reading of information from the first memory cell and the writing of information into the second memory cell.

The drive unit may be configured to move the optical medium relative to the optical network during a first time period. The at least one copy operation may be carried out after or during the first time period. Optionally, a plurality of copy operations are performed during the first time period and during the moving of the optical medium. With each copy operation information may be written into a different second memory cell of the optical medium. The plurality of copy operations may comprise a first copy operation and a second copy operation. The second copy operation may be carried out after the first copy operation. The first copy operation may comprise reading information from a first memory cell and writing information into a second memory cell. The second copy operation may comprise reading information from another first memory cell into another second memory cell. The first memory cell may be partially spatially overlapping with the second memory cell. The another first memory cell may be partially spatially overlapping with the another second memory cell. The second memory cell of the first copy operation may be (spatially) identical with the another first memory cell of the second copy operation, i.e. fully spatially overlapping.

The plurality of copy operations may comprise at least two copy operations, preferably at least three copy operations. More specifically, a copy operation may be performed every *Δt* seconds during the first time period and/or during the moving of the optical medium (copy-on-move operation). Optionally, the optical medium may be moved during the first time period at a constant speed for performing copy operations during the first time interval. The time spacing between the first copy operation and the second copy operation may be the time interval *Δt.*

The constant speed and/or the time interval *Δt* between two copy operations may be determined according to a critical degradation threshold of the optical medium and/or according to a size of a memory cell. The critical degradation threshold may be determined by the degradation of the/a first memory cell(s) due to repeatedly writing information into the/a first memory cell(s). The critical degradation threshold may be the maximum number of times information can be written into a same memory cell, e.g., a first memory cell, before this memory cell degrades, e.g., as determined according to a quality measure of the memory cell. Optionally, the time interval *Δt* is in a range between 1 microsecond and 1000 microseconds. Optionally, the size of a memory cell may be in a range between 0,5 Microns and 10 Microns.

The optical input-output device may also be configured to perform a copy operation (only) upon reaching the critical degradation threshold of a/the first memory cell(s) of the plurality of memory cells (copy-on-N-writes). In this case, the optical medium may be moved (only) once the critical degradation threshold is reached. Optionally, in this case the optical medium is not moved at a constant speed during the first time period. For example, the moving of the optical medium may stop between two copy operations. Alternatively, the moving of the optical medium may be performed at a lower speed between two copy operations as compared to the speed of moving during a copy operation.

Optionally, before a copy operation or between two copy operations at least one or each write unit of the plurality of write units may write information a number of times into a/the same (first) memory cell(s). The number of times information is written into the same memory cell may correspond to the maximum number of times information can be written into a same memory cell, e.g., a first memory cell, before this memory cell degrades, e.g., according to a quality measure of the memory cell.

A second aspect relates to an optical output device comprising an optical network having a plurality of read units. The optical output device is configured for performing read operations on an optical medium having a plurality of memory cells.

Each read unit according to the second aspect is configured to receive a read signal and propagate the read signal further towards the optical medium for reading out information stored in the memory cell. Each read unit according to the second aspect is further configured to receive the read signal modulated by the memory cell back from the optical medium and couple the modulated read signal back into the optical network for further processing.

The optical output device according to the second aspect may be configured with one or several features as described with respect to the optical input-output device according to the first aspect or any variant of the first aspect. The read unit(s) according to the second aspect may be configured as the read unit(s) according to the first aspect or any variant of the first aspect.

A third aspect relates to an optical input device comprising an optical network having a plurality of write units. The optical input device is configured for performing write operations on an optical medium having a plurality of memory cells.

Each write unit according to the third aspect is configured to receive a write signal and propagate the write signal further towards a memory cell of the plurality of memory cells for writing information into the memory cell by interacting with the memory cell.

The optical input device according to the third aspect may be configured with one or several features as described with respect to the optical input-output device according to the first aspect or any variant of the first aspect. The write unit(s) according to the third aspect may be configured as the write unit(s) according to the first aspect or any variant of the first aspect.

In a fourth aspect, the invention relates to an optical system. The optical system comprises an optical input-output device according to the first aspect or any variant thereof. In the fourth aspect, the optical network of the optical input-output device is a first optical network.

The optical system further comprises a second optical network for performing optical computations. The second optical network is coupled or connected to the first optical network.

The first optical network is configured to receive from the second optical network a result derived from an optical computation performed by the second optical network. The first optical network is further configured to write the result, by at least one write unit of the plurality of write units, into at least one memory cell of the plurality of memory cells.

Alternatively, or additionally, the first optical network is configured to send to the second optical network an information read out by at least one read unit of the plurality of read units from at least one memory cell of the plurality of memory cells for using the information as an input to an optical computation to be performed by the second optical network.

Preferably, the optical computation may comprise a matrix-vector multiplication. The result derived from the optical computation and to be written in at least one memory cell may comprise at least one matrix element. For example, the matrix element may be a weight learned from a learning algorithm during training. In this case, the optical computation may comprise or consist of or be part of training a neural network. The information to be read out from at least one memory cell may comprise a matrix element. For example, the matrix element may be a weight for a learning algorithm during inference. In this case, the optical computation may comprise or consist of or be part of applying a trained neural network during interference.

A fifth aspect relates to an optical system according to the fourth aspect or any variant thereof, wherein the optical input-output system is replaced by an optical input system according to the second aspect.

A seventh aspect relates to an optical system according to the fourth aspect or any variant thereof, wherein the optical input-output system is replaced by an optical output system according to the third aspect.

In a seventh aspect, the invention relates to an optical input-output method for performing read and write operations on an optical medium having a plurality of memory cells by using an optical input-output device comprising an optical network having a plurality of read units and a plurality of write units. The optical input output device may be configured according to the first aspect or any variant thereof.

The method comprises carrying out at least one read step and at least one write step.

Each read step of the at least one read step comprises receiving, by at least one, preferably by each, read unit of the plurality of read units, a read signal and propagating the read signal further towards the optical medium for reading out information stored in a first memory cell of the plurality of memory cells.

Each read step further comprises receiving, by at least one, preferably by each, read unit of the plurality of read units, the read signal modulated by the first memory cell back from the optical medium and coupling the modulated read signal back into the optical network for further processing.

Each write step of the at least one write step comprises receiving, by at least one, preferably by each, write unit of the plurality of write units, a write signal and propagating the write signal further towards the optical medium, preferably towards a second memory cell of the plurality of memory cells, for writing information into a second memory cell by interacting with the optical medium, preferably with the second memory cell.

The method may further comprise changing with which memory cell(s) of the plurality of memory cells at least one, preferably each, read unit of the plurality of read units and/or at least one, preferably each, write unit of the plurality of write units stands in optical communication by moving, by a drive unit of the optical input output device, the optical medium relative to the optical network. The moving of the optical medium may ensure that the at least one write unit becomes optically coupled with the second memory cell, preferably to be able to perform a copy operation for copying information from the first memory cell to the second memory cell.

The method may further comprise moving, by a drive unit of the optical input output device, the optical medium relative to the optical network at a constant speed during a first time period. The method may also comprise performing a copy operation every *Δt* seconds during the first time period, wherein each copy operation comprises copying information from a first memory cell to a second memory cell by performing a write step after a read step. The first memory cell may be partially spatially overlapping with the second memory cell.

Optionally, the method further comprises writing, by at least one, preferably each, write unit of the plurality of write units, information several times into at least one same (first) memory cell of the plurality of memory cells until a critical degradation threshold is reached. Upon reaching the critical degradation threshold the method may comprise moving, by a drive unit of the optical input output device, the optical medium relative to the optical network, e.g., for a predetermined distance. After or during moving, the method may comprise copying information last written to the same memory cell to a second memory cell by performing a copy operation, wherein the copy operation comprises: reading information last written to the same (first) memory cell by performing a read step by at least one read unit of the plurality of read units; and writing the information last written to the same (first) memory cell into a new (second) memory cell by performing a write step by at least one write unit of the plurality of write units.

An eight aspect relates to a computer program comprising instructions which, when the program is executed by a computer using an optical input output device, cause the computer to carry out the optical input output method according to the seventh aspect or any combination of its features as described above. The computer program (or a sequence of instructions) may use software means for performing the optical input output method when the computer program runs in a computing unit/device. The computer program can be stored directly in an internal memory, a memory unit, or the computer.

A ninth aspect relates to a computer-readable data carrier having stored there on the computer program described with respect to the eight aspect or any variant thereof. The computer program can be stored in machine-readable data carrier(s), preferably digital storage media.

In summary, the proposed invention enables energy efficient all-optical input output for a dynamical all-optical memory solution that can be easily integrated in an optical system together with an optical computing device to facilitate integrated all optical processing. The proposed devices and methods can be particularly useful in the context of large-scale computations and simulations where intermediary results of the computation or simulation need to be stored and be retrieved at a high frequency, e.g., to in-situ change the parameters of the computation or simulation. For example, in artificial intelligence training weights of a neural network need to be optimized and adapted requiring frequent input and output. Other applications range from high-performance computing, in particular super-computing, large simulations, e.g., weather simulations or physics simulations, to artificial intelligence training and inference, machine learning, deep learning and related settings.

Features of the different aspects can be combined with one another and can also be claimed individually.

### Brief summary of the drawings

Exemplary embodiments of the invention are illustrated in the drawings and will now be described with reference to figures 1a to 9.

In the figures:
- Fig. 1a: shows a cross section view of a first example of an optical input-output device and an optical medium,
- Fig. 1b: shows a top view of an example of a read/write unit with a read unit and a write unit,
- Fig. 2: shows a cross section view of a second example of an optical input-output device and an optical medium,
- Fig. 3: shows a top view of an example of an optical input-output device with a Mach-Zehnder interferometer network and an optical medium,
- Fig. 4: shows a top view of an example of an optical input-output device with a Crossbar array,
- Fig. 5: shows a top view of an example of an optical input-output device with a Crossbar array and an optical medium,
- Fig. 6: shows a top view of an example of an optical input-output device with a Crossbar array and an optical medium in a conveyor belt configuration,
- Fig. 7: shows a top view of read/write unit and a rotatable optical medium,
- Fig. 8: shows a schematic process flow of a copy operation,
- Fig. 9: shows spatially overlapping memory cells during a copy operation.

### Detailed description of the Drawings

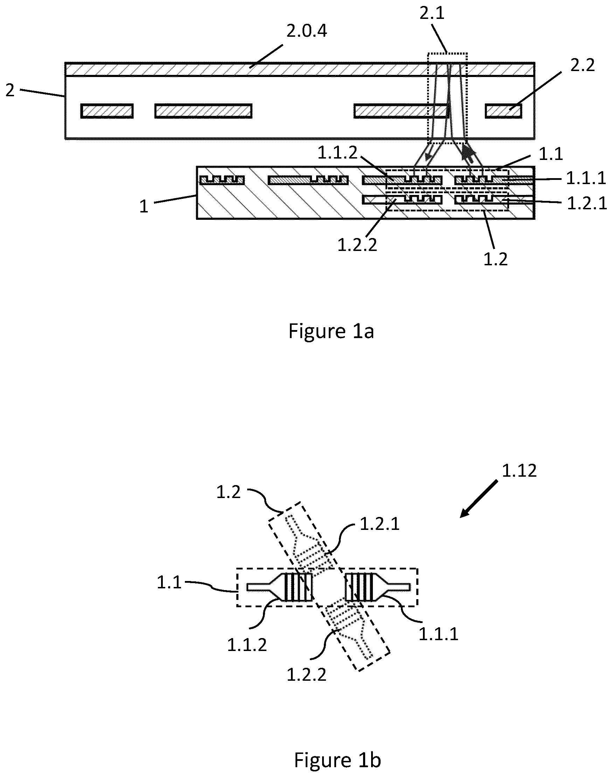

Figure 1a shows a cross section view of an example of an optical input-output device with an optical network 1 and an optical medium 2.

The optical network 1 has a plurality of read units 1.1 and a plurality of write units 1.2 for performing read and write operations on the optical medium 2.

The optical network 1 is an integrated photonic circuit. The read units 1.1 are arranged in a first layer of the integrated photonic circuit and form a first waveguide array. The write units are arranged in a second layer of the integrated photonic circuit and form a second waveguide array. The first layer is over the second layer.

Each read unit 1.1 is configured to receive a read signal from the optical network 1 and propagate the read signal further towards a memory cell 2.1 of the plurality of memory cells 2.1 for reading out information stored in the memory cell 2.1.

Each read unit 1.1 is further configured to receive the read signal modulated by the memory cell 2.1 back from the memory cell 2.1 and couple the modulated read signal back into the optical network 1 for further optical processing.

More specifically, each read unit 1. comprises a first grating coupler 1.1.1 for coupling the read signal out of the first layer of the optical network 1 and propagating the read signal further towards the optical medium 2. Each read unit 1.1 of the plurality of read units also comprises a second coupler 1.1.2 for coupling a modulated read signal coming from the optical medium 2 back into the first layer of the optical network 1.

The first 1.1.1 and second 1.1.2 coupler of each read unit 1.1 are grating coupler that are spaced apart from each other and are each connected to a waveguide of the first waveguide array.

Each write unit 1.2 is configured to receive a write signal and propagate the write signal further towards a memory cell 2.1 of the plurality of memory cells 2.1 for writing information into the memory cell 2.1 by interacting with the memory cell 2.1.

Each write unit 1.2 of the plurality of write units comprises a third coupler 1.2.1 and a fourth coupler 1.2.2 for coupling a write signal out of the second layer of the optical network 1 and propagating the write signal further towards the optical medium 2.

The third 1.2.1 and fourth 1.2.2 coupler of each write unit 1.2 are grating coupler that are also spaced apart from each other and are each connected to a waveguide of the second waveguide array.

A read signal is different in terms of wavelength and power from a write signal. Therefore, the first 1.1.1 and second 1.1.2 grating coupler of a read unit 1.1 also differ from the third 1.2.1 and fourth 1.2.2 grating coupler of a write unit 1.2 in terms of a periodicity of the grating.

The optical medium 2 has a plurality of memory cells 2.1. The optical medium 2 also comprises a phase change material 2.2. In this specific embodiment, the phase change material is germanium-antimony-tellurium, GST. Each memory cell 2.1 comprises a portion of a phase change material 2.2. A portion of the phase change material 2.2 can be in an amorphous phase or can be in a crystalline phase. An amorphous phase may be associated with a logic 0 corresponding to a bit value 0. A crystalline phase may be associated with a logic 1 corresponding to a bit value 1.

A write signal pulse interacting with a memory cell 2.1 heats up a portion of the PCM of the memory cell 2.1 and after the write signal pulse has turned off, the portion of the PCM cools down into a crystalline or into an amorphous phase depending on the pulse shape, duration and intensity. Thus, the write signal is configured to set the phase of the portion of the PCM and thereby write information into the memory cell 2.1, i.e., a bit 0 or a bit 1. Note, that in another embodiment, a memory cell may also be a multi-level cell storing more than one bit. This can be realized by fine-tuning the write signals to bring the PCM in intermediary phases/states, e.g., intermediary phases between amorphous and crystalline or by combining a portion of an amorphous phase and a crystalline phase within one memory cell 2.1. Alternatively, the may be achieved by combining portions of both, the crystalline and the amorphous phase, in one memory cell 2.1.

A read signal propagating from a read unit 1.1 to the optical medium 2 and interacting with a memory cell 2.1 is configured to only probe the portion of the PCM of said memory cell 2.1 weakly so as to not change the phase of the portion of the PCM of said memory cell 2.1. However, an amorphous phase has different optical properties than a transparent phase, i.e., an amorphous phase is more transparent and less absorbent for a read signal as compared to a crystalline phase. Thus, a read signal that arrives from a read unit 1.1 of the optical network 1 and interacts with a memory cell 2.1 by passing through the portion of the PCM 2.2 will experience a different absorption depending on the phase of the portion of PCM 2.2 of said memory cell 2.1. Therefore, the memory cell 2.1 will modulate at least the amplitude of the read signal differently depending on which information is stored in said memory cell 2.1. For example, when the memory cell 2.1 stores a bit 0 (amorphous phase), the amplitude of the modulated read signal after having passed through the portion of the PCM of said memory cell 2.1 will be smaller compared to a case when the memory cell 2.1 stores a bit 1 (crystalline phase). Therefore, the information stored in the memory cell 2.1 is encoded in the modulated read signal coming from the optical medium 2 and arriving back at the read unit 1.1 after having probed the memory cell 2.1.

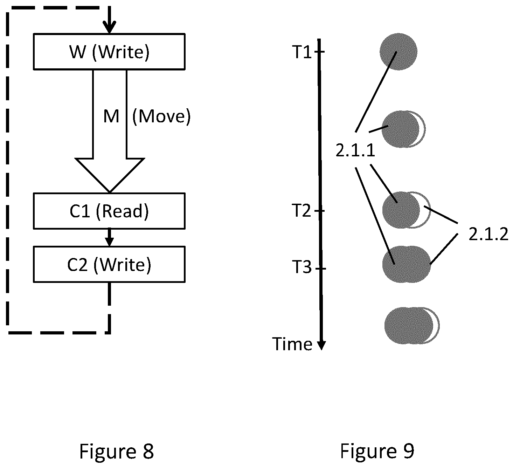

It is noted that the optical medium 2 has a reflection layer 2.0.4 over the PCM layer 2.2 to reflect the read signal back towards the optical network 1. In this case, it is possible that a read signal passes through the PCM layer twice. Depending on the precise geometry and size of a memory cell, the choice or (potential) combination of portions of a PCM within a memory cell 2.1, as well as the propagation angles and path defined by the various grating couplers, various applications scenarios can be realized, and the modulation of a read signal can be fine-tuned. It may also be convenient that the optical mode of a read signal or the read signal beam only partially spatially overlap with a memory cell 2.1 for reading out information from said memory cell 2.1 as explained in more detail in relation to the embodiment shown in Figure 9.

Figure 1b shows a top view of an example of a read unit 1.1 and a write unit 1.2 belonging to a same read/write unit 1.12. In this top view, the write unit 1.2 is in the second layer below the read unit 1.1 in the first layer. The read unit 1.1 has a symmetry axis that is rotated (rotationally shifted) with respect to a symmetry axis of the write unit 1.2 with a rotation axis normal to the first and second layer. This helps to avoid interference between read and write signals and the associated modes.

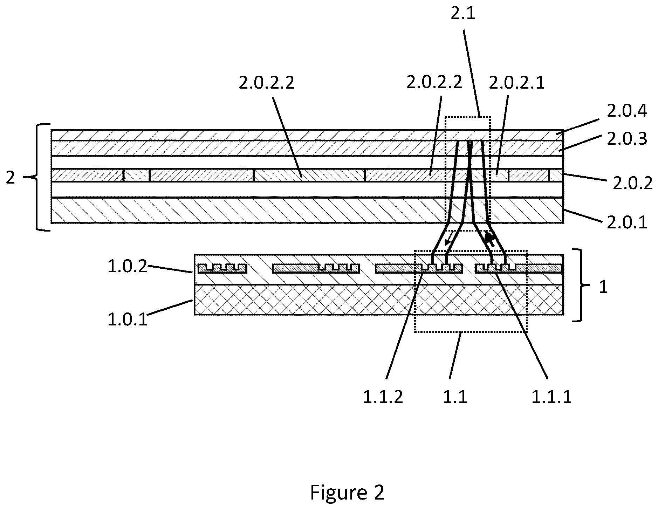

Figure 2 shows a cross section view of a second example of an optical input-output device and an optical medium 2. The example shown in Figure 2 is similar to the one in Figure 1, but the optical medium 2 comprises more layers and the read units 1.1 and the write units 1.2 (not shown in Figure 2) are arranged in a same layer 1.0.2.

The optical medium 2 comprises a plurality of layers 2.0.1, 2.0.2, 2.0.3, 2.0.4. The first layer 2.0.1 is a common substrate made of polycarbonate. The second, third and fourth layers 2.0.2, 2.0.3, 2.0.4 of the optical medium 2 are arranged over the common substrate 2.0.1.

The second layer 2.0.2 is a patterned optical material layer comprising a phase-change material, PCM. The PCM is patterned by the write units 1.2. The phase change material thus comprises first-type regions 2.0.2.1 corresponding to portions of the phase change material in a first phase and second type regions 2.0.2.2 corresponding to portions of the phase change material in a second phase.

In this specific embodiment, the phase change material is germanium-antimony-tellurium, GST. The first phase is an amorphous phase and is substantially transparent to optical read signals. The second phase is a crystalline phase and is highly absorbent for optical read signals. In particular, the first phase is more transparent and less absorbent than the second phase. The phase change material is embedded in a dielectric material that separates the phase change material from the substrate 2.0.1 and third and fourth layers 2.0.3, 2.0.4.

In the example shown in Figure 2, the memory cell 2.1 that is (currently) in optical communication with the read unit 1.1 comprises a portion of a first-type region 2.0.2.1 and a portion of a second-type region 2.0.2.2. In an alternative embodiment, a memory cell 2.1 may also comprise always only one type of region as discussed further above. Depending on how first-type and second-type regions are arranged and combined in the respective memory cells 2.1, different modulation and absorption of a read signal may be realized in each of the memory cells 2.1.

The optical medium 2 further comprises a reflective metal layer 2.0.3 as a third layer and a protective hard coating 2.0.4 as a fourth layer. The reflective metal layer 2.0.3 and the protective hard coating 2.0.4 are configured to reflect a signal coming from the optical network 1 back to the optical network 1. Figure 2 thus shows a reflection geometry. In this embodiment, the reflective metal layer 2.0.3 comprises or consists of Silver.

The optical medium 2 is spaced apart from the optical network 1 in a direction normal to the first to fourth layers 2.0.1, 2.0.2, 2.0.3, 2.0.4 of the optical medium 2 and the optical network 1.

The optical network 1 shown in Figure 2 comprises a substrate 1.0.1 made from Silicon as a first layer 1.0.1 and a second layer 1.0.2 stacked over and on the substrate 1.0.1. The second layer 1.0.2 comprises the read units 1.1 with the first and second couplers 1.1.1, 1.1.2 and the write units 1.2 (not shown in Figure 2). The second layer 1.0.2 also comprises waveguides connected to the first and second couplers 1.1.1, 1.1.2. In this embodiment, the read units 1.1, write units 1.2 and the waveguides are embedded in a silicon dioxide cladding as part of the second layer 1.0.2. The waveguides together with read units 1.1 and the write units 1.2 form a waveguide array and are made from silicon nitride.

It is noted that Figure 2 shows a reflection configuration. However, in another example the optical input-output device may also be configured in transmission configuration. For example, the first couplers 1.1.1 of the read units 1.1 may be arranged in a first layer and the second couplers 1.1.2 of the read units 1.1 may be arranged in a second layer spaced apart from the first layer. The optical medium 2 may then be placed in between the first and second layer. In this case it may be convenient if the first layer belongs to a first die and the second layer belongs to a second die. The first and second die are then part of the same optical network 1.

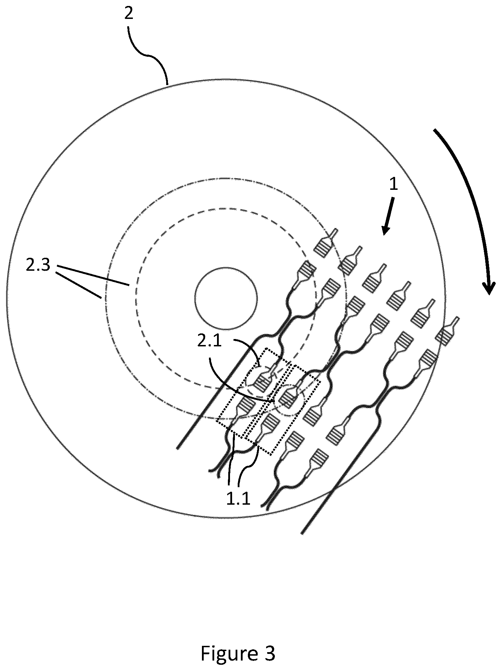

Figure 3 shows a top view of an example of an optical input-output device with a waveguide array as a Mach-Zehnder interferometer network and an optical medium 1 with a plurality of memory cells 2.1. The waveguide array comprises the read units 1.1. The write units 1.2 are in a layer below the read units 1.1 and are not shown in figure 3 for simplicity of presentation. Each read unit 1.1 is in optical communication with a different first memory cell 2.1 of the plurality of memory cells 2.1 of the optical medium 2. The first memory cells 2.1 form a subset of the plurality of memory cells. This subset comprises all memory cells 2.1 that are currently (i.e., as shown in Figure 3) optically coupled to the read units 1.1.

The optical medium 2 is a disc. The memory cells 2.1 are arranged in circular tracks 2.3 of the disc. The tracks 2.3 are spaced from each other and each track 2.3 comprises multiple memory cells 2.1. Each track 2.3 stands in optical communication with another read/write unit 1.12, i.e., with another read unit 1.1 of the plurality of read units 1.1 and another write unit 1.2 of the plurality of write units 1.2, through one first memory cell 2.1 of the multiple memory cells 2.1 of each track 2.3.

So, Figure 3 represents a time snapshot wherein each one of the two first memory cells 2.1 that are depicted as encircled and that belong to two different tracks 2.3 is in optical communication with a different read and write unit 1.12, i.e. a read unit 1.1 and a write unit 1.2, that is (currently) overlapping with a respective track 2.3.

The optical medium 2 is removably/interchangeably mounted such that the optical medium 2 can be removed and replaced, i.e., such that another optical medium 2 can be mounted.

In particular, the optical input output device comprises a mounting unit (not shown in Figure 3). The mounting unit is configured to receive and mount the optical medium 2 thereby bringing the optical medium 2 in optical communication with the optical network 1. Additionally, the mounting unit is configured to release the optical medium 2 for exchanging the (current) optical medium 2 with another optical medium 2.

The optical medium 2 is also movably mounted for changing the memory cells 2.1 with which the read units 1.1 and the write units 1.2 are optically coupled. More specifically, the optical medium 2 is rotatably mounted.

The optical input-output device also comprises a drive unit (not shown in Figure 3). The drive unit is part of the mounting unit. The drive unit is configured to rotate the optical medium 2 around a normal vector of an optical network layer 1 (i.e., a normal vector pointing out of the plane of Figure 3).

By rotating the optical medium 2, the read/write units 1.12, i.e., the read units 1.1 and the write units 1.2, of the optical network 1 can be brought into optical communication with a new set of second memory cells 2.1 of the plurality of memory cells 2.1 of the optical medium 2. In particular, by rotating the optical medium 2, the memory cells 2.1 that stand in optical communication with the read/write units 1.1 of the optical network 1 change. Note that each track 2.3 comprises at least a first memory cell 2.1 and a second memory cell 2.1.

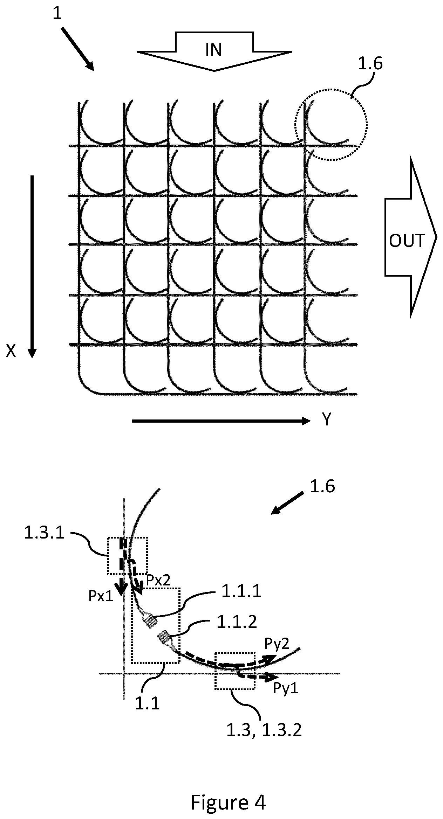

Figure 4 shows another embodiment of an optical network 1 that comprises or consists of a crossbar array. A unit cell 1.6 of the crossbar array may comprise a read unit 1.1 or a write unit 1.2, wherein each read unit 1.1 and write unit 1.2 of the crossbar array is configured as described with respect to the embodiments discussed in relation to Figures 1 to 3.

In particular, a read unit 1.1 of a unit cell 1.6 comprises a first grating coupler 1.1.1 and a second grating coupler 1.1.2 as shown in the lower panel of Figure 4. Note, that the unit cells 1.6 depicted in the upper panel of Figure 4 seem to show no couplers. However, the couplers have not been depicted in the upper panel simply due to limited resolution. In fact, each unit cell 1.6 in the upper panel comprises either a read unit 1.1 or a write unit 1.2 as described further above.

Moreover, each unit cell 1.6 of the crossbar array comprises two waveguide coupling elements, a first waveguide coupling element 1.3.1 and a second waveguide coupling element 1.3.2. The first waveguide coupling element 1.3.1 of each unit cell 1.6 couples at least a portion Px2 of an input signal propagating along the x-direction as a first read signal into the read unit 1.1 of the unit cell 1.6. The other portion Px1 of the input signal is propagated further towards a neighboured unit cell 1.6 in x-direction. The second waveguide coupling element 1.3.2 receives a modulated read signal from the first read unit 1.1 and couples at least a portion Py1 of the modulated read signal into a waveguide in y-direction for further processing. A crossbar array in a first layer of the optical network then comprises the plurality of read units 1.1, wherein each read unit 1.1 is part of a unit cell 1.6. of the crossbar array in the first layer. A second layer of the optical network 1 comprises the plurality of write units 1.2 wherein each write unit 1.2 is part of a unit cell 1.6. of the crossbar array in the second layer.

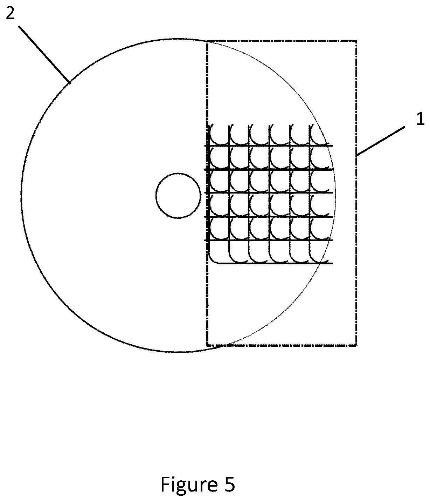

Figure 5 shows a crossbar array as an optical network 1 together with an optical medium 2. In particular, in the crossbar array shown in Figure 5 each read unit 1.1 of a unit cell 1.6 is optically coupled to a (different) memory cell 2.1 of the optical medium 2.

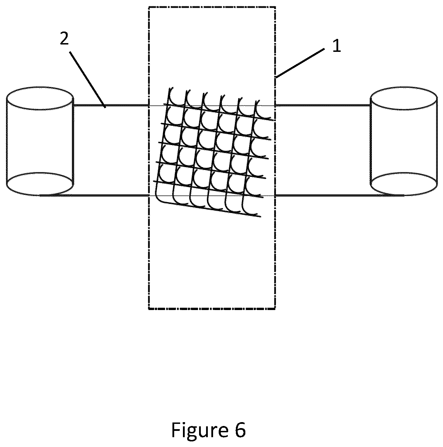

Figure 6 shows another embodiment of the optical medium 2, wherein the optical medium 2 comprises a linear tape. In this case, the optical medium 2 is translatorily mounted for performing a translation of the optical medium 2 relative to the optical network 1. In this case, the drive unit is configured to translate the optical medium 2 in a direction parallel to an in-plane vector (e.g., in the x-y plane) of the crossbar array as the optical network 1 for changing the memory cells 2.1 that are optically coupled with the read units 1.1 and the write units 1.2. The optical input-output device thus comprises a conveyor belt configuration.

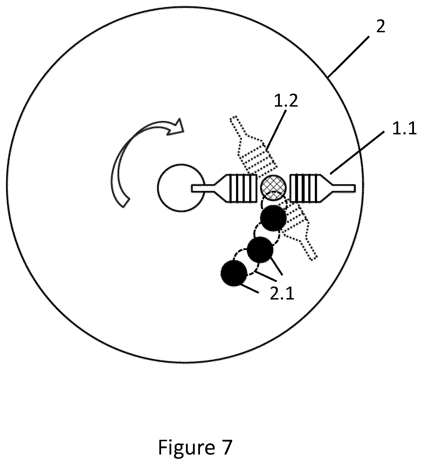

Figure 7 shows a top view of a read/write unit 1.12 comprising a read unit 1.1 and a write unit 1.2 and a disc as a rotatable optical medium 2. The read unit 1.1 and the write unit 1.2 are optically coupled and stand in optical communication with a first memory cell 2.1 of the optical medium 2. The optical medium 2 is moved, i.e., rotated, by the drive unit of the optical input-output device relative to the optical network 1 for changing the memory cell 2.1 of the optical medium 2 that is currently optically coupled with the read unit 1.1 and the write unit 1.2. By rotating the optical medium 2 a second memory cell 2.1 in the same track 2.3 as the first memory cell becomes optically coupled to the read unit 1.1 and the write unit 1.2. Rotating the optical memory 2 thus allows to obtain a fresh new second memory cell 2.1 for writing and/or reading by the same read unit 1.1 and write unit 1.2. The memory cells 2.1 shown in Figure 7 as black filled circles seem discretely spaced apart from each other. However, those memory cells 2.1 just represent a subset of memory cells 2.1 corresponding to those memory cells 2.1 of the circular track that comprise the PCM in a crystalline phase. In this embodiment, those memory cells 2.1 store a logic 1. In between the memory cells 2.1 storing a logic 1 there are additional memory cells 2.1 (see dotted lines in Figure 7) that comprise PCM in an amorphous (white spaces between black circles) and this represent a logic 0. Here, the convention is that the phase change material is in an amorphous phase before writing to the phase change material. The writing may result either in leaving the phase change material in an amorphous phase (memory cell storing logic 0) or changing the phase of a portion of the phase change material into crystalline thereby defining a memory cell storing logic 1. The memory cells 2.1 of the track shown in Figure 7 are then spatially overlapping.

This also means that a previous memory cell 2.1 that is amorphous and stores a logic 0 will be partially overwritten when the next memory cell 2.1 that spatially overlaps with the previous memory cell 2.1 is crystalline and stores a logic 1.

Figure 8 relates to an optical input-output method. The input-output method comprises a step W of writing information, by a write unit 2.1, into a first memory cell 2.1, 2.1.1. The method further comprises moving the optical medium 2 relative to the optical network 1 and carrying out a read step C1 and a write step C2. The read step C1 comprises receiving, by the read unit 1.1 a read signal and propagating the read signal further towards the optical medium 2 for reading out information stored in the first memory cell 2.1, 2.1.1 of the plurality of memory cells 2.1. The read step C1 further comprises receiving, by the read unit 1.1, the read signal modulated by the first memory cell 2.1, 2.1.1 back from the first memory cell 2.1, 2.1.1 and coupling the modulated read signal back into the optical network 1 for further processing.The write step C2 then comprises receiving, by the write unit 1.2, a write signal and propagating the write signal further towards the second memory cell 2.1. 2.1.2 for writing information into the second memory cell 2.1 by interacting with the second memory cell 2.1. Here, the write signal carries the information read out by the read signal so that the information is copied from the first memory cell 2.1.1 to the second memory cell 2.1.2.

The input-output method shown in Figure 8 can be performed in two different modes of operation, as a copy-on-move operation (first mode) or as a copy-on-N-writes operation (second mode).

In the first modus, a copy-on-move operation comprises moving the optical medium at a constant speed during a first time period and performing multiple copy operations C1, C2 during the first time period, wherein a copy operation C1,C2 is performed every *Δt* seconds during the first time period. In particular, the multiple copy operations C1, C2 comprise more than 2 copy operations that are equidistantly spaced in time with the time period *Δt.*

In certain embodiments, it may be the case that in a copy operation a read step C1 is performed substantially simultaneously by all read units 1.1 of the plurality of read units and the write step C2 is performed after the read step C2 substantially simultaneously by all write units 1.2 of the plurality of write units 1.2. In this way all the information stored in the plurality of first memory cells 2.1, 2.1.1 optically coupled to the read units 1.1 during the read step C1 is copied completely to the plurality of second memory cells 2.1,2.1.2 optically coupled to the write units 1.2 during the write step C2.

The constant speed and the time period *Δt* are determined by a critical degradation measure of the plurality of memory cells 2.1, i.e., of the PCM. This is determined as follows:
First it is noted that the optical PCM degrades when it is repeatedly written to. A critical degradation threshold corresponds to a maximum number of times N that a same memory cell or the PCM at a same location can be written to before a certain degradation level is observed or simulated. For a typical optical PCM this can be more than 100.000 times.

Moreover, it is assumed that a memory cell 2.1 is written to a statistical amount of K times per second, e.g., by an optical computation performed by another optical network that that is coupled to the optical network 1 and stores intermediate results of the optical computation into the optical medium 2 by using the optical network 1, i.e., the plurality of write units 1.2. The value of K is application specific, e.g., K may vary from 10 times to 10.000 times and more. For example, for an optical compute application that comprises artificial intelligence inference K may be very small. However, for artificial intelligence training K may be 1.000.000 or even larger. The value K is predetermined. In an alternative embodiment, the value of K may also be determined in-situ based on a running application and may also be adapted. In some embodiments, the value K can be estimated based on a program code for a compute application or can be determined from previously obtained measurements and/or statistics.

To ensure a fresh memory cell that has not yet degraded is optically coupled to the optical network 1, the optical medium 2 is rotated at a constant rotation speed so that the write units 1.2 are coupled to new memory cells 2.1 every N/K seconds, i.e., *Δt = N*/*K* in seconds.

For a size L in microns of a memory cell 2.1, the optical memory 2 is then rotated at a constant speed given by (K/N)*L in microns per second. Thus, the constant speed depends on the critical degradation threshold N and a size L of a memory cell 2.1.

The optical medium 2 is replaced using the mounting unit once a full rotation has been achieved.

In the second mode, a copy-on-N-writes operation is performed. The second mode comprises writing, by at least one write unit 1.2 of the plurality of write units 1.2 information a number of times to at least one same first memory cell 2.1, 2.1.1 of the plurality of memory cells 2.1 until a critical degradation threshold is reached, wherein the critical degradation threshold corresponds to a maximum number of times N information is written to the at least one same first memory cell 2.1, wherein N is an integer larger than 1. In the copy-on-N-writes operation only upon reaching the critical degradation threshold the optical medium 2 is moved and a copy operation C1, C2 is performed as described further above.

After information has been copied from first memory cells 2.1, 2.1.1 to second memory cells 2.1, 2.1.2, moving of the optical medium is paused (or slowed significantly) at least until the write unit 1.2 has again written information a maximum number of times N now to the new second memory cell 2.1, 2.1.2. Upon reaching this critical degradation threshold for the second memory cell 2.1, 2.1.2 the second mode comprises again moving the optical medium 2 and performing a further copy operation C1, C2.

These steps are repeated until the whole track 2.3 and the optical medium 2 is fully written to after which the optical medium 2 is interchanged and a new (unwritten) optical medium 2 is mounted.

The copy-on-N-writes operation is distinct from the prior art known copy-on-write operation where information is copied after writing to a memory cell only once. The copy-on-N-writes operation is also distinct from the copy-on-move operation as in the latter case the optical medium 2 is moved at a constant speed during a plurality of copy operations, while in a copy-on-N-writes operation the moving of the optical medium 2 stops or considerably slows between two copy operations C1, C2.

It is also noted, that the term "writing information a number of times" does not necessarily mean that the same information is written a number of times. Each time a different information may be written into a same memory cell 2.1.

Figure 9 shows spatially overlapping memory cells 2.1, 2.1.1, 2.1.2 to further illustrate the optical input-output method comprising a copy operation as discussed above.

At a first time instance T1, the write unit 2.1 writes information into a first memory cell 2.1.1 by changing the phase of a portion of the phase change material from amorphous to crystalline (filled circle at T1 in Figure 9). During moving the optical medium 2 relative to the optical network 1, the read unit 1.1 and the write unit 1.2 move relative to the first memory cell 2.1.1 and thus also the optical modes that couple the read unit 1.1 and the write unit 1.2 with the optical medium 2 move relative to the first memory cell 2.1.1 (to the right in Figure 9). In Figure 9, the modes of the read unit 1.1 and the modes of the write unit 1.2 fully overlap.

At a second time instance T2 (step C1) the optical modes (as depicted by the empty circle at T2 in Figure 9) still partially overlap with the first memory cell 2.1.1, wherein the partial overlap is more than 50 percent. Thus, at the second time instance T2, the read unit 1.1 receives a read signal and propagates it to the optical medium 2 for reading out the first memory cell 2.1.1. Even though the optical mode of the read signal has only partial overlap anymore with the first memory cell 2.1.1, the modulation of the modulated read signal by the optical medium 2 is still dominated and determined by the portion of the phase change material belonging to the first memory cell 2.1.1, so that the information stored in the first memory cell 2.1.1 (logic 1 in Figure 9) can be uniquely determined based on the modulated read signal obtained back from the optical medium 2 by the read unit 1.1. For that purpose, the plurality of read units 1.1 and the plurality of write units 1.2 are coupled to an evaluation unit (not shown) of the optical network 1 that is configured to carry out further processing. The evaluation unit evaluates the modulated read signals and determines the information stored in the respective first memory cells 2.1.1 based on the modulated read signals. Based on said information, corresponding write signals are generated for copying said information to new second memory cells 2.1.2.

At a third time instance T3 (step C2) immediately following the second time instance T2, the write unit 1.2 writes the information last written to the first memory cell 2.1.1 as determined by the evaluation unit based on the modulated read signals into the new second memory cells 2.1.2. In Figure 9, since the information is simply copied that means that the phase of the second memory cell 2.1.2 is changed from amorphous to crystalline. It is noted, that here in this embodiment an empty optical medium that has not yet been written to comprises a phase change material layer being entirely in the amorphous phase. The steps described above may then be repeated to copy information from the second memory cell further to a third memory cell etc.

It is noted that before information gets written into the second memory cell 2.1.2 in step C2, the region ahead of the first memory cell 2.1.1, i.e., a part of the region of the second memory cell 2.1.2, is in a predetermined known state or phase, i.e., the transparent phase in Figure 9, since no information has yet been written into said region. Therefore, the evaluation unit is perfectly capable of uniquely determining the state/phase of the first memory cell 2.1.1 based on the modulated read signal even though the mode of the read signal only partially overlaps with the first memory cell 2.1.1 at the second time instance T2.

Of course, it may also be the case that between two copy operations one or more write steps are performed that overwrite or write new information into a memory cell such that some memory cells 2.1 in the same track 2.3 may also store a logic 0 (see non-filled circles 2.1 in Figure 7) while others of the same track 2.3 may store a logic 1 (filled circles). It also noted that the time interval from the first time instance T1 to the second time instance T2 is much longer than the time interval from the second time instance T2 to the third time instance T3, so that the copy operation C1, C2 can be considered instantaneous for all practical purposes.

Features of the different embodiments which are merely disclosed in the exemplary embodiments as a matter of course can be combined with one another and can also be claimed individually.

## Claims

1. An optical input-output device comprising
an optical network (1) having a plurality of read units (1.1) and a plurality of write units (1.2) for performing read and write operations on an optical medium (2) having a plurality of memory cells (2.1), wherein
each read unit (1.1) is configured to receive a read signal and propagate the read signal further towards the optical medium (2) for reading out information stored in a memory cell (2.1) of the plurality of memory cells (2.1); and
each read unit (1.1) is further configured to receive the read signal modulated by the memory cell (2.1) back from the optical medium (2) and couple the modulated read signal back into the optical network (1) for further processing; and
each write unit (1.2) is configured to receive a write signal and propagate the write signal further towards the optical medium (2) for writing information into a memory cell (2.1) of the plurality of memory cells by interacting with the optical medium (2).

2. The optical input-output device according to any previous claim, wherein the optical network (1) is an integrated photonic circuit.

3. The optical input-output device according to any previous claim, wherein the plurality of read units (1.1) are arranged in one or more parallel layers of the optical network (1) and/or the plurality of read units (1.1) are overlapping a same substrate (1.0.1) of the optical network (1) and/or the plurality of write units (1.2) are arranged in one or more parallel layers of the optical network (1) and/or the plurality of write units (1.2) are overlapping a same substrate (1.0.1) of the optical network (1).

4. The optical input-output device according to any previous claim, wherein the optical network (1) comprises or consists of a waveguide array, wherein each read unit (1.1) of the plurality of read units (1.1) and/or each write unit (1.2) of the plurality of write units (1.2) is connected to a waveguide of the waveguide array and/or the plurality of read units (1.1) are coupled by waveguides of the waveguide array and/or the plurality of write units (1.2) are coupled by waveguides of the waveguide array.

5. The optical input-output device according to any previous claim, wherein each read unit (1.1) of the plurality of read units comprises a first coupler (1.1.1) for coupling a read signal out of a layer of the optical network (1) and propagating the read signal further towards the optical medium (2) and/or each read unit (1.1) of the plurality of read units comprises a second coupler (1.1.2) for coupling a modulated read signal coming from the optical medium (2) back into a layer of the optical network (1) and/or each write unit (1.2) of the plurality of write units comprises at least a third coupler (1.2.1) for coupling a write signal out of a layer of the optical network (1) and propagating the write signal further towards the optical medium (2).

6. The optical input-output device according to any previous claim comprising a mounting unit configured to receive the optical medium (2) and mount the optical medium (2) interchangeably and/or movably.

7. The optical input-output device according to any previous claim further comprising a drive unit configured to move the optical medium (2) relative to the optical network (1) for changing at least one memory cell (2.1) of the optical medium (2) optically coupled with at least one of the read units (1.1) of the plurality of read units and/or with at least one of the write units (1.2) of the plurality of write units.

8. The optical input-output device according to any previous claim further configured to perform a copy operation (C1, C2), wherein a copy operation (C1, C2) comprises reading (C1), by at least one read unit (1.1) of the plurality of read units, information stored in a first memory cell (2.1) of the optical medium (2); and writing (C2), by at least one write unit (1.2) of the plurality of write units, the information read out from the first memory cell (2.1) into a second memory cell (2.1) of the optical medium (2).

9. The optical input-output device according to claim 8, wherein the second memory cell (2.1) is partially spatially overlapping with the first memory cell (2.1).

10. The optical input-output device according to claim 8 or 9 further configured to perform a plurality of copy operations during a first time period, wherein the drive unit is configured to move the optical medium (2) relative to the optical network (1) during the first time period.

11. The optical input-output device according to any one of claims 7 to 10, wherein the drive unit is configured to move the optical medium (2) at a constant speed relative to the optical network (1), wherein the constant speed is determined by a critical degradation threshold of the optical medium (2).

12. An optical input-output method for performing read and write operations on an optical medium (2) having a plurality of memory cells (2.1) by using an optical input-output device comprising an optical network (1) having a plurality of read units (1.1) and a plurality of write units (1.2), the method comprising carrying out at least one read step (C1) and at least one write step (C2), wherein
each read step (C1) of the at least one read step comprises
receiving, by at least one read unit (1.1) of the plurality of read units, a read signal and propagating the read signal further towards the optical medium (2) for reading out information stored in a memory cell (2.1) of the plurality of memory cells; and
receiving, by at least one read unit (1.1) of the plurality of read units, the read signal modulated by the memory cell (2.1) back from the optical medium (2) and coupling the modulated read signal back into the optical network (1) for further processing; and
each write step (C2) of the at least one write step comprises
receiving, by at least one write unit (1.2) of the plurality of write units, a write signal and propagating the write signal further towards the optical medium for writing information into a memory cell (2.1) of the plurality of memory cells by interacting with the optical medium (2).

13. The optical input output method according to claim 12, wherein the method further comprises performing a copy operation, wherein the copy operation comprises reading out information from a first memory cell (2.1) of the plurality of memory cells by performing the read step (C1) and writing the information read out from the first memory cell (2.1) into a second memory cell (2.1) of the plurality of memory cells by performing the write step (C2).

14. The optical input output method according to claim 12 or 13, wherein the method further comprises moving the optical medium (2) relative to the optical network (1) for changing with which memory cell (2.1) of the plurality of memory cells at least one first read unit (1.1) of the plurality of read units and/or at least one write unit (1.2) of the plurality of write units stands in optical communication.

15. The optical input output method according to claim 12, 13 or 14, wherein the method comprises
writing, by at least one write unit (2.1) of the plurality of write units, several times to at least one same first memory cell (2.1) of the plurality of memory cells (2.1) until a critical degradation threshold is reached;
and upon reaching the critical degradation threshold moving, by a drive unit of the optical input output device, the optical medium (2) relative to the optical network (1), and copying information last written to the first memory cell (2.1) to a second memory cell (2.1) by performing a copy operation (C1, C2).
